Europäisches Patentamt

European Patent Office

Office européen des brevets

(11) Publication number: **0 420 485 A1**

## EUROPEAN PATENT APPLICATION

(21) Application number: 90310237.4

(22) Date of filing: 19.09.90

(51) Int. Cl.5: **H01L 29/60**, H01L 29/72, H01L 29/74

(30) Priority: 25.09.89 GB 8921596

(43) Date of publication of application:
03.04.91 Bulletin 91/14

(84) Designated Contracting States:
DE ES FR GB IT

(71) Applicant: **LUCAS INDUSTRIES PUBLIC LIMITED COMPANY**
**Brueton House, New Road**
**Solihull, West Midlands B91 3TX(GB)**

(72) Inventor: **Finney, Adrian David**
**27, Oakhurst Road**
**Acocks Green, Birmingham, B27 7PH(GB)**

(74) Representative: **Robinson, John Stuart et al**
**Marks & Clerk Alpha Tower Suffolk Street**
**Queensway**
**Birmingham, B1 1TT(GB)**

(54) MOS gated bipolar devices.

(57) A MOS gated bipolar device, such as a transistor, has alternating layers (1-4) of conductivity type. The surface of an intermediate layer (2) separates and forms junctions with another layer (3). In one form, gate regions (17) overlie the junctions only. In another form, the gate (27a, 27b) overlies the junctions and the surface of the intermediate layer (2), but with a greater spacing from that surface.

FIG 3

The present invention relates to MOS gated bipolar devices, such as insulated gate bipolar transistors (IGBT) and MOS gated thyristors. Mos gated bipolar devices are characterised by being conductivity modulated as opposed to field effect devices, which function solely by majority carrier mechanisms.

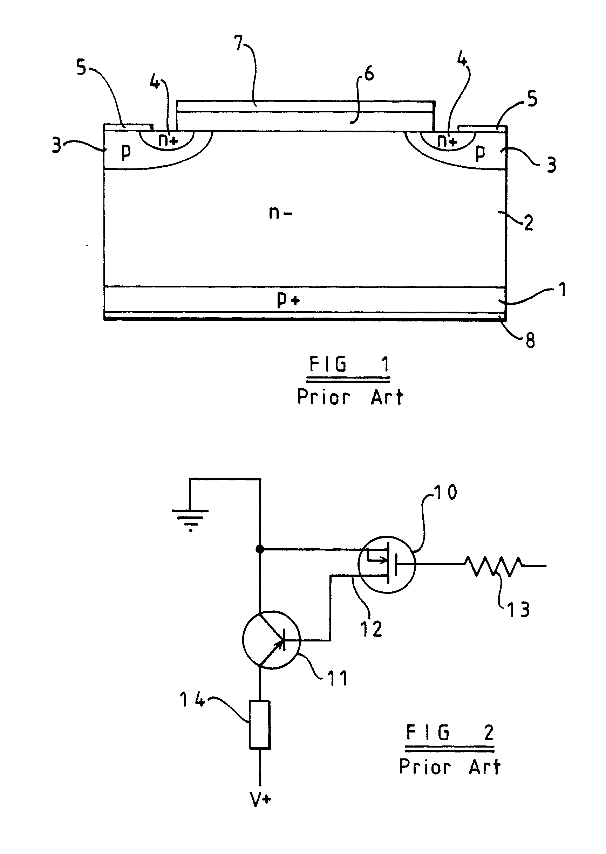

Figure 1 of the accompanying drawings shows an enlarged cross sectional view (not to scale) of a known type of insulated gate bipolar transistor. The transistor comprises an anode layer or region 1 formed by a layer of monocrystaline silicon which has been relatively highly doped with p-type material. The anode region 1 is provided with a lower metallisation layer 8 forming an anode contact of the device. Above the anode layer 1 is a region 2 of monocrystaline silicon which is lightly doped with a n-type impurity. Within the region 2 are formed regions 3 doped with p-type material, within which are regions 4 which are highly doped with n-type material. The regions 3 and 4 are, for instance, formed by implantation or diffusion of suitable impurities. A metallised contact layer 5 is deposited on the regions 3 and 4 so as to connect them together electrically, and forms a cathode contact of the device.

A layer 6 of insulating material, such as silicon dioxide, is formed on the upper surface of the region 2 and overlies parts of the regions 3 and 4 and the upper surface of the region 2 therebetween. A conductive layer 7 typically of amorphous or polycrystaline silicon is formed above the insulating layer 6 and provides a gate electrode of the device. The layer 7 is provided with electrical contacts (not shown) for external connection.

Insulated gate bipolar transistors are well known and the detailed operation of the transistor shown in Figure 1 will not therefore be described. Such devices can be used for high power switching and amplifying applications and are capable of operating at high frequencies.

Figure 2 is a diagram illustrating an equivalent circuit of the transistor shown in Figure 1. Although other equivalent circuits for analysing operation of the transistor may be formed, the circuit shown in Figure 2 will be used to explain a problem which can arise with insulated gate bipolar transistors.

The circuit of Figure 2 shows an insulated gate field effect transistor 10 controlling a bipolar junction transistor 11. The gate of the field effect transistor is provided by the gate electrode 7 and the source electrode corresponds to the region 4. The drain electrode indicated by 12 in Figure 2 is connected to the base of the transistor 11, corresponding to the region 2. The source of the transistor 12 is connected to the collector of the transistor 11, corresponding to the region 5. A series resistor 13 is formed by the resistance of the gate electrode 7 and an optional external series resistor which is effectively added in series with the gate electrode. The cathode electrode 5 is connected to a common voltage supply terminal or earth and the anode electrode 8 is connected via a load 14 to a positive supply terminal V+.

In certain applications, relatively large voltage spikes characterised by having very high rates of change of voltage are produced across the anode and cathode terminals of the insulated gate transistor. For instance, such spikes may be generated when switching current through a load 14 which has a substantial inductive component. These spikes are passed from the anode electrode of the transistor by the Miller effect to the base region 2. As is well known, the base region 2 is separated from the gate electrode 7 by a relatively thin insulating layer provided by the layer 6. There is thus a substantial Miller capacitance between the base region 2 and the gate 7 (gate-drain capacitance). A second capacitance exists between layers 3-4 and gate 7 (gate-source capacitance). The thin dielectric of the layer 6 can be damaged by excessive voltages across these capacitors, thus destroying the transistor. However, the thickness of the layer 6 is required to be sufficiently small so as to endow the transistor with sufficient transconductance or sensitivity. The thickness of the layer 6 therefore has to be a compromise between the conflicting requirements of increased transconductance and sensitivity to breakdown during normal operation.

However, when a voltage spike of relatively high rate of change of voltage is supplied to the base region 2, the gate electrode 7 is charged and, because of the inherent time constant formed by the two capacitances and the resistor 13, the voltage across the gate-source capacitor can turn on the device, or exceed the breakdown voltage of the insulation layer 6 thus destroying the device.

According to a first aspect of the invention, there is provided a MOS gated bipolar device comprising a plurality of layers of alternating conductivity type and an insulated gate, at least one of the layers at a first end of the plurality of layers comprising first and second regions separated by a surface of an intermediate one of the layers, the insulated gate comprising first and second gate regions separated from each other and overlying the junctions between the surface of the intermediate layer and the first and second regions, respectively.

According to a second aspect of the invention, there is provided a MOS gated bipolar device comprising a plurality of layers of alternating conductivity type and an insulated gate, at least one of the layers at a first end of the plurality of layers comprising first and second regions separated by a surface of an intermediate one of the layers, the insulated gate comprising first and second gate regions overlying the junctions between the surface of the intermediate layer and the first and second regions, respectively, and spaced therefrom by respective first insulating layers, and a third gate region overlying the surface of the intermediate layer and spaced therefrom by a second insulating layer having a thickness greater than that of the first insulating layers.

The invention will be further described, by way of example, with reference to the accompanying drawings, in which :-

Figure 1 is a cross sectional diagram of a known type of insulated gate bipolar transistor;

Figure 2 shows an equivalent circuit of the transistor of Figure 1;

Figure 3 is a cross sectional diagram of an insulated gate bipolar transistor constituting a first embodiment of the invention; and

Figure 4 is a cross sectional diagram of an insulated gate bipolar transistor constituting· a second embodiment of the invention.

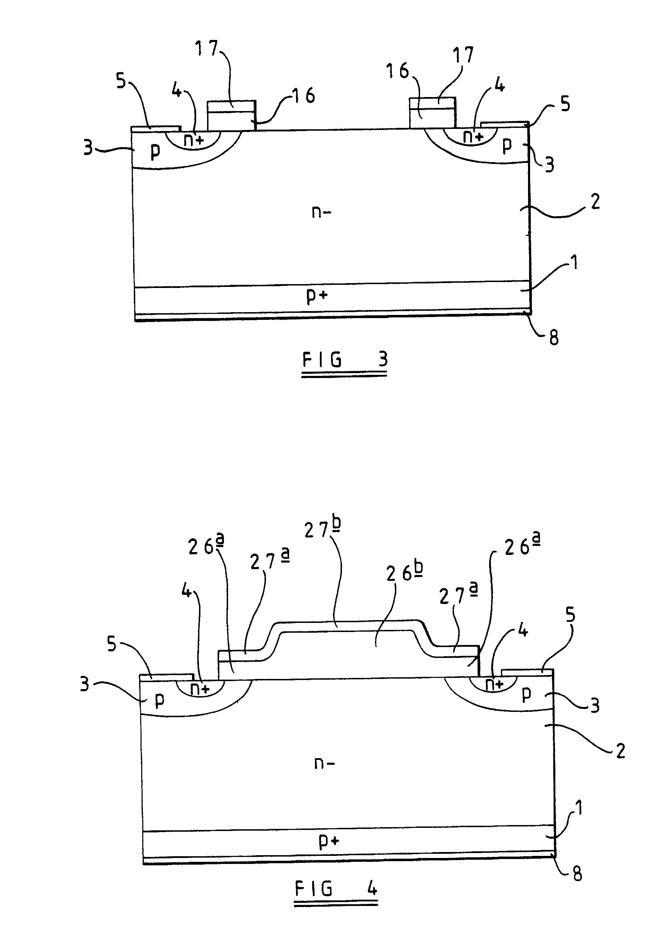

Like numerals refer to corresponding parts throughout the drawings. Accordingly, the parts of the transistors shown in Figures 3 and 4 which correspond to parts shown in Figure 1 and described hereinbefore will not be described further.

The insulated gate bipolar transistor shown in Figure 3 differs from that shown in Figure 1 in that the insulation layer 6 and the gate electrode 7 are replaced by separate insulation layers 16 and gate electrodes 17. Each of the insulation layers 16 and the gate electrodes 17 overlies the junctions between the regions 2, 3, and 4. However, the insulation layers 16 and the gate electrodes 17 are spaced apart so as not to overlie substantially the surface of the region 2 between the regions 3. The gate electrodes 17 are electrically connected together in order to form a single gate for controlling conduction of the transistor.

The insulated gate bipolar transistor shown in Figure 4 differs from that shown in Figure 1 in that the insulating layer 6 and the gate electrode 7 are replaced by an insulating layer having portions 26a overlaid by portions 27a of a gate electrode and a portion 26b overlaid by a portion 27b of the gate electrode. The portions 26a of the insulating layer overlie the junctions between the regions 2, 3, and 4 of the transistor whereas the portion 26b of the insulating layer, which is of greater thickness than the portions 26a, overlies the surface of the region 2 between the regions 3. Thus, the capacitance between the region 2 and the portion 27b of the gate electrode in the transistor of Figure 4 is substantially lower than the capacitance between the region 2 and the gate electrode 7 of the transistor shown in Figure 1.

The transistors shown in Figures 3 and 4 thus have substantially lower capacitances between the gate electrodes and the base regions than for transistors of known type as illustrated in Figure 1. Accordingly, when such transistors are subjected to voltages of relatively large rates of change, such as spikes, the resulting voltages induced on the gate electrode are of substantially lower values. Accordingly, the transistors shown in Figures 3 and 4 will withstand much greater rates of change of voltage than known types of transistors before turning on or suffering any damage to the gate insulation layers. However, the spacing between the gate electrodes and the junctions between the regions 2, 3, and 4 need not be altered in comparison with the known transistors, so that the sensitivity or transconductance of the transistors is not adversely affected by the new gate structures.

Transistors of the type shown in Figure 3 have the advantages that gate-drain capacitance is minimised and such transistors can be manufactured by processes which do not require any additional steps. Transistors of the type shown in Figure 4 do require additional process steps during manufacture in order to form the insulating layer with portions 26a and 26b of different thicknesses. However, such transistors have the advantage of reduced gate resistance because of the greater areas of the gate electrodes compared with the transistors of Figure 3.

The techniques which have been described hereinbefore with respect to insulated gate bipolar transistors can also be applied to other types of devices, such as MOS gated thyristors, and provide the same advantages compared with known devices of this type.

## Claims

1. A MOS gated bipolar device comprising a plurality of layers of alternating conductivity type and an insulated gate, at least one of the layers at a first end of the plurality of layers comprising first and second regions separated by a surface of an intermediate one of the layers, characterised in that the insulated gate (17) comprises first and second gate regions separated from each other and overlying junctions between the surface of the intermediate layer (2) and the first and second regions (3, 4), respectively.

2. A MOS gated bipolar device comprising a plurality of layers of alternating conductivity type and an insulated gate, at least one of the layers at a first end of the plurality of layers comprising first and second regions separated by a surface of an intermediate one of the layers, characterised in that the insulated gate comprises first and second gate regions (27a), overlying junctions between the surface of the intermediate layer (2) and the first and second regions (3, 4), respectively, and spaced therefrom by respective first insulating layers (26a), and a third gate region (27b) overlying the surface of the intermediate layer (2) and spaced therefrom by a second insulating layer (26b) having a thickness greater than that of the first insulating layers (26a).

FIG 1
Prior Art

FIG 2
Prior Art

FIG 3

FIG 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 050 773 (SIEMENS AG) <br> * Page 2, line 17 - page 4, line 4; page 4 - page 6, lines 6-24; figures 1,5 * | 1,2 | H 01 L 29/60 <br> H 01 L 29/72 <br> H 01 L 29/74 |
| X | GB-A-2 088 631 (GENERAL ELECTRIC CO.) <br> * Figures 9,11 * | 1 | |
| X | IEE PROCEEDINGS SECTION A à I, vol. 132, no. 6, part I, December 1985, pages 261-263; H. YILMAZ et al.: "50 A 1200 V n-channel IGT" <br> * Figure 2 * | 2 | |

|  | TECHNICAL FIELDS SEARCHED (Int. Cl.5) |
|---|---|
|  | H 01 L |

The present search report has been drawn up for all claims

| Place of search | Date of completion of search | Examiner |
|---|---|---|
| The Hague | 10 December 90 | MORVAN D.L.D. |